# EUROPEAN PATENT APPLICATION

(11) **EP 2 495 956 A1**
(43) Date of publication of application: **05.09.2012**
(21) Application number: 10826292.4
(22) Date of filing: 18.10.2010
(51) Int. Cl.: H04N 5/335, H01L 27/146

(54) **SOLID-STATE IMAGING DEVICE**

(30) Priority: 27.10.2009 JP 2009246261
(71) Applicant: Konica Minolta Advanced Layers, Inc., Hachioji-shi Tokyo 192-8505 (JP)
(72) Inventor: IWAMOTO, Tsuyoshi, Hino-shi Tokyo 191-8511 (JP); MORIMOTO, Takashi, Hino-shi Tokyo 191-8511 (JP); KUSUDA, Masayuki, Hino-shi Tokyo 191-8511 (JP)
(74) Representative: HOFFMANN EITLE
(86) International application number: PCT/JP2010/006169
(87) International publication number: WO 2011/052155

(57) **Abstract**

Provided is a solid-state imaging device comprising a plurality of pixel circuits GC having photoelectric conversion characteristics including linear characteristics and logarithmic characteristics on either side of an inflection point. The pixel circuits GC each include a photoelectric conversion element PD which accumulates a signal charge by exposing a subject, and a floating diffusion FD which converts the signal charge accumulated by the photoelectric conversion element PD into a voltage signal. The floating diffusion FD is set to have an operating charge that is smaller than a saturation charge of the photoelectric conversion element PD.

## Description

### Technical Field

The present invention relates to a solid-state imaging device of CMOS type.

### Background Art

In recent years, a solid-state imaging device has become known which, in order to increase the dynamic range, comprises a pixel circuit having linear log characteristics including linear characteristics on a low brightness side of an inflection point and logarithmic characteristics on a high brightness side thereof.

For example, Patent Document 1 discloses a pixel circuit which comprises an embedded-type photodiode and a transfer transistor that transfers the signal change accumulated in the photodiode to a floating diffusion, and which logarithmically compresses the signal charge accumulated in the photodiode and achieves linear log characteristics by driving a transfer gate at an intermediate potential during an exposure period.

The pixel circuit described in Patent Document 1 employs an embedded-type photodiode, and is therefore able to suppress dark current which occurs at the surface of the photodiode, as well as being able to suppress variation in the signal component caused by the dark current in each pixel circuit. Furthermore, the pixel circuit described in Patent Document 1 removes a noise component by means of correlated double sampling, and therefore is able to remove kTC noise which is produced when the floating diffusion is reset.

The pixel circuit described in Patent Document 1 makes no mention of the relationship between the saturation charge of the photodiode and the operating charge of the floating diffusion. The floating diffusion is required to accumulate all of the signal charge accumulated in the photodiode, and therefore the operating charge of the floating diffusion is generally set to be larger than the saturation charge of the photodiode.

However, when using an embedded-type photodiode, the sensitivity of the pixel circuit is determined principally by the operating charge of the floating diffusion, rather than the saturation charge of the photodiode. Consequently, if the saturation charge of the photodiode is made larger, the operating charge of the floating diffusion must also be made larger, accordingly, and there is risk of decline in sensitivity.

More specifically, the voltage of the floating diffusion is dependent on the number of electrons transferred from the photodiode, but if the operating charge of the floating diffusion becomes large, then the amount of change in the voltage of the floating diffusion in relation to one electron becomes small, the charge to voltage conversion coefficient which defines the relationship between the signal charge transferred to the floating diffusion and the voltage becomes small, and therefore the sensitivity of the pixel circuit declines.

Patent Document 1 : Japanese Patent Application Publication No. 2006-50544

### Summary of the Invention

It is an object of the present invention to provide a solid-state imaging device capable of improving sensitivity while also suppressing decline in the dynamic range.

The solid-state imaging device according to one aspect of the present invention is a solid-state imaging device of CMOS type, comprising a plurality of pixel circuits having photoelectric conversion characteristics including linear characteristics and logarithmic characteristics on either side of an inflection point, wherein the pixel circuits each include: a photoelectric conversion element which accumulates a signal charge by exposing a subject; and a floating diffusion which converts the signal charge accumulated by the photoelectric conversion element into a voltage signal, and the floating diffusion is set to have an operating charge smaller than a saturation charge of the photoelectric conversion element.

### Brief Description of the Drawings

[Fig. 1] Fig. 1 is a general schematic drawing of a solid-state imaging device according to an embodiment of the present invention.
[Fig. 2] Fig. 2 is a circuit diagram of a pixel circuit according to an embodiment of the present invention.
[Fig. 3] Fig. 3A is a timing chart of a pixel circuit, and Fig. 3B is a graph showing the photoelectric conversion characteristics of a pixel circuit which is driven in accordance with the timing chart in Fig. 3A.
[Fig. 4] Fig. 4A is a modification example of a timing chart of the pixel circuit shown in Fig. 2, and Fig. 4B is a graph showing the photoelectric conversion characteristics when a pixel circuit is driven in accordance with the timing chart in Fig. 4A.
[Fig. 5] Fig. 5 shows a timing chart when a pixel circuit is driven with linear characteristics rather than linear log characteristics.
[Fig. 6] Fig. 6A shows a potential chart of a pixel circuit when the pixel circuit is driven with linear characteristics, and Fig. 6B is a potential chart of a pixel circuit for describing the QPD and the QFD.
[Fig. 7] Fig. 7A shows a potential chart during an exposure period when a pixel circuit designed so as to satisfy the relationship QPD > QFD is driven with linear log characteristics, and Fig. 7B shows a potential chart during a transfer when a pixel circuit designed so as to satisfy the relationship QPD > QFD is driven with linear log characteristics.
[Fig. 8] Fig. 8 is a graph showing the photoelectric conversion characteristics of a pixel circuit which is driven with linear characteristics.
[Fig. 9] Fig. 9 is a comparison diagram showing cases where a pixel circuit which satisfies the relationship CPD > CFD is driven with linear log characteristics or with linear characteristics.
[Fig. 10] Fig. 10 shows a circuit diagram of the column ADC shown in Fig. 1.
[Fig. 11] Fig. 11 is a timing chart showing the operation of the column ADC depicted in Fig. 10.
[Fig. 12] Fig. 12A shows a timing chart when the solid-state imaging device according to an embodiment of the present invention reads out a pixel signal for one frame, and Fig. 12B is an arrangement map of a case where pixel data output from a solid-state imaging element is arranged as one image, in accordance with the timing chart in Fig. 12A.
[Fig. 13] Figs. 13A to 13F show arrangement patterns of color filters attached to respective pixel circuits GC.
[Fig. 14] Fig. 14A is a layout diagram of a pixel circuit according to a comparative example, and Fig. 14B is a layout diagram of a pixel circuit according to the present embodiment.

### Description of Embodiments

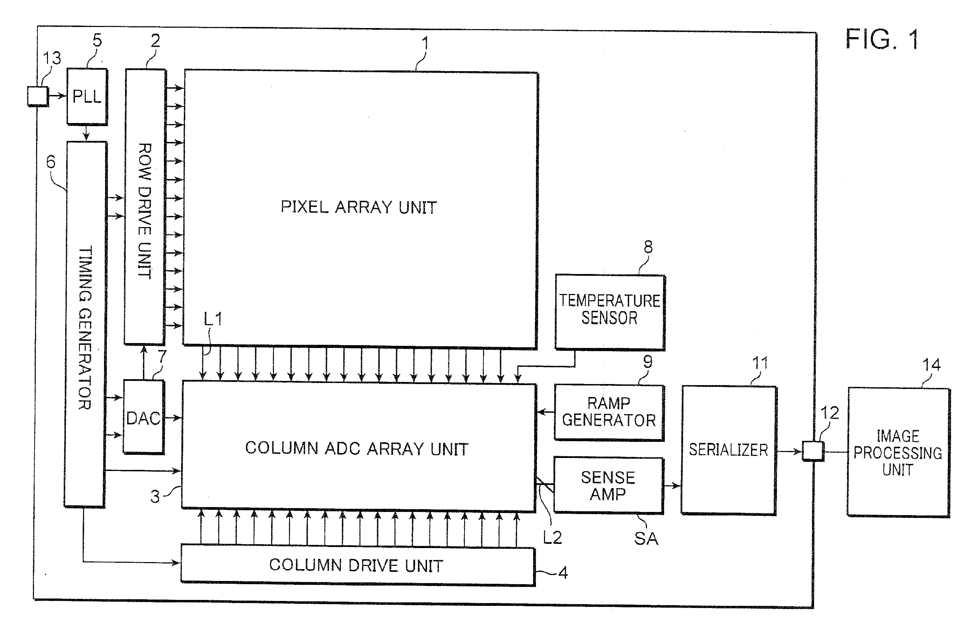

Below, the solid-state imaging device according to an embodiment of the present invention is described with reference to the drawings. Fig. 1 is a general schematic drawing of a solid-state imaging device according to an embodiment of the present invention. As shown in Fig. 1, the solid-state imaging device is a solid-state imaging device of CMOS (Complementary Metal Oxide Semiconductor) type based on a parallel column AD conversion method (column AD conversion method), comprising: a pixel array unit 1, a row drive unit 2 (one example of a vertical scanning unit), a column ADC array unit 3 (one example of a reading unit), a column drive unit 4, a PLL 5, a timing generator 6 (one example of a control unit), a DAC 7 (one example of a control unit), a temperature sensor 8 (one example of a temperature detection unit), a ramp generator 9, a sense amp SA, a serializer 11, an output terminal 12, a clock terminal 13 and an image processing unit 14.

In the present embodiment, the parts aside from the image processing unit 14, namely, the pixel array unit 1 to the clock terminal 13, are integrated onto one chip and constitute a solid-state imaging element.

The pixel array unit 1 is constituted by a plurality of pixel circuits GC (not illustrated) arranged in a matrix configuration of M rows (where M is a positive integer no less than 2) x N columns (where N is a positive integer no less than 2). In the example in Fig. 1, the pixel circuits GC are arranged in a matrix configuration of 14 rows x 18 columns.

The row drive unit 2 comprises a vertical scanning circuit and a driver circuit, for instance. The vertical scanning circuit is constituted by a shift register, for example, and vertically scans the pixel array unit 1 by selecting the pixel circuits GC of each row constituting the pixel array unit 1, cyclically, in synchronism with a vertical synchronization signal which is output from the timing generator 6.

The driver circuit generates a pixel control signal and drives the pixel circuits GC by outputting the pixel control signal to the pixel circuits GC belonging to the row selected by the vertical scanning circuit.

The column ADC array unit 3 comprises N column ADCs (one example of a reading circuit) corresponding to the respective columns of the pixel array unit 1, and one column ADC for converting analog temperature data output from the temperature sensor 8 into digital data. The column ADCs are connected to the pixel circuits GC of each column via a vertical signal line L1 corresponding to each column of the image array unit 1, and read out pixel signals from the pixel circuits of the row selected by the vertical scanning circuit. A correlated double sampling process and an analog digital conversion process are applied to the signal and the digital image signal thus obtained is saved.

The column drive unit 4 is constituted by a shift register, for example, and by outputting a column selection signal which is synchronized with the horizontal synchronization signal output from the timing generator 6, the column ADC of each column is selected cyclically in one horizontal scanning period, the column ADC array unit 3 is scanned horizontally, and the digital image signals held by the column ADCs of each column are output successively to the sense amp SA.

The PLL 5 multiplies a clock signal (SYSCLK) supplied from an external device, via the clock terminal 13, and outputs the signal to the timing generator 6. In the present embodiment, a 54 MHz clock signal is supplied to the clock terminal 13, for example, and the PLL 5 multiplies this 54 MHz clock signal by 2 and supplies a 108 MHz clock signal to the timing generator 6.

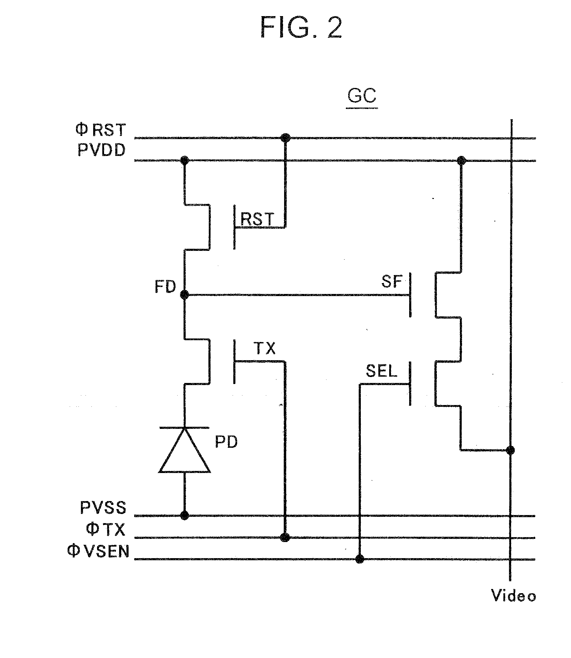

The timing generator 6 controls the whole of the solid-state imaging device by generating timing signals required to control the solid-state imaging device, such as a vertical synchronization signal and a horizontal synchronization signal, in accordance with the clock signal supplied from the PLL 5. Furthermore, the timing generator 6 includes a register for storing set values of the timing signal, and the like. Set values are written to the register by, for instance, serial communication with an external device which is connected via a communication terminal (not illustrated). Here, the set values include a set value for determining the value of an intermediate potential for driving the transfer transistor TX (see Fig. 2) which is described hereinafter, for example.

In the present embodiment, in the pixel array unit 1, pixel circuits GC of a plurality of types for acquiring pixel signals for a plurality of color components, such as red (R), green (G) and blue (B), for instance, are arranged in regular fashion according to a prescribed arrangement method, such as a Bayer arrangement. Accordingly, the timing generator 6 stores predetermined set values which designate an intermediate potential for each type of pixel circuit GC, in the register. The timing generator 6 controls the DAC 7 and the row drive unit 2 in such a manner that each pixel circuit GC is driven by the intermediate potential designated by the set value corresponding to that type of pixel circuit GC.

More specifically, the timing generator 6 previously stores which types of pixel circuits GC are arranged in each row and each column of the image array unit 1. When the row drive unit 2 has selected any one row, the timing generator 6 identifies which type of pixel circuit GC is arranged in each column of that row, and outputs the set value corresponding to the identified type, to the DAC 7. The timing generator 6 causes the DAC 7 to convert the set value from digital to analog. The set value which has been converted from digital to analog is input to the row drive unit 2. Under the control of the timing generator 6, the row drive unit 2 outputs the intermediate potential designated by the input set value to the transfer transistor TX of the pixel circuits GC of each of the selected columns.

In this way, by driving the pixel circuits GC with the intermediate potential corresponding to the type of circuit, each pixel circuit GC is able to achieve a suitable dynamic range corresponding to the type of circuit.

Furthermore, the timing generator 6 changes the intermediate potential for each pixel circuit GC on the basis of the temperature data detected by the temperature sensor 8, so as to suppress variation in the inflection point each of pixel circuit GC.

Here, the temperature data detected by the temperature sensor 8 is converted to digital temperature data in the column ADC array unit 3, and then output to the image processing unit 14. The image processing unit 14 corrects the intermediate potential determined for each type of pixel circuit GC, in accordance with the temperature data converted to digital data, and writes the set values which designate the corrected intermediate potentials in the register of the timing generator 6. Here, the image processing unit 14 previously stores a function indicating the relationship between the intermediate potential and the temperature, for each type of pixel circuit GC, for example, and determines an intermediate potential corresponding to the temperature detected by the temperature sensor 8, in accordance with this function. The image processing unit 14 should then write the set values for driving the pixel circuits at the determined intermediate potentials, in the register.

The timing generator 6 should then drive the transfer transistor TX of the pixel circuits GC in accordance with the set values rewritten by the image processing unit 14. By this means, variation in the inflection point of each pixel circuit GC due to variation in the junction temperature is suppressed.

The DAC (digital analog converter) 7 converts the digital signal output from the timing generator 6, to an analog signal, which is then supplied to the row drive unit 2. For instance, the DAC 7 generates an intermediate potential and supplies this potential to the row drive unit 2, by converting the set value for designating the intermediate potential output from the timing generator 6, into an analog signal.

The temperature sensor 8 detects the junction temperature, which is the internal temperature of the solid-state imaging device, and outputs analog temperature data directly proportional to the junction temperature, to the column ADC to which the pixel circuits GC are not connected. In the example in Fig. 1, the column ADC of the rightmost column of the column ADC array unit 3 is employed as the column ADC which is not connected to the pixel circuits GC. The temperature data output from the temperature sensor 8 is output to this column ADC of the rightmost column and converted from analog to digital.

The ramp generator 9 generates a ramp signal which is output to the column ADCs. The sense amp SA amplifies the digital image signal output from the column ADC array unit 3 via the horizontal signal line L2 and outputs the signal to the serializer 11. In the present embodiment, the column ADC generates a 14-bit digital image signal, shifts the phase of the signal of each bit through 180°, and outputs a total of 28 signals comprising signals shifted through a phase of 180° and signals which are not phase shifted, to the sense amp SA. Consequently, there is a total of 28 horizontal signal lines L2 which connect the column ADC array unit 3 and the sense amp SA. The sense amp SA respectively amplifies the signals flowing in the 28 horizontal signal lines L2, shapes the waveforms of the respective signals, and outputs the signals to the serializer 11.

The serializer 11 is constituted by a serializer which complies with LVDS (Low Voltage Differential Signalings) standards, for example, and performs differential amplification of the signals output in parallel from the sense amp SA via the 28 horizontal signal lines L2, to obtain a 14-bit signal, which is converted to a parallel signal and output to the output terminal 12. The output terminal 12 outputs the signal from the serializer 11 to the image processing unit 14.

The image processing unit 14 is constituted by a dedicated hardware circuit, for example, and carries out various image processes on the image signals output from the column ADCs. In the present embodiment, the image processing unit 14 specifies the intermediate potential applied to the gate of the transfer transistor TX of each pixel circuit GC, in accordance with the temperature data detected by the temperature sensor 8 as described above, and implements processing for suppressing variation in the inflection point.

Fig. 2 shows a circuit diagram of a pixel circuit GC. As shown in Fig. 2, the pixel circuit GC is constituted by a CMOS pixel circuit GC comprising a photoelectric conversion element PD, a transfer transistor TX, a reset transistor RST, an amplification transistor SF, and a row selection transistor SEL.

The photoelectric conversion element PD receives light from a subject and accumulates signal change corresponding to the received amount of light. Here, the anode of the photoelectric conversion element PD is earthed, and the cathode is connected to the source of the transfer transistor TX. A drive voltage, PVSS, is input to the anode of the photoelectric conversion element PD.

The transfer transistor TX transfers the signal change accumulated by the photoelectric conversion element PD to a floating diffusion (hereinafter, abbreviated as "FD"). A drive voltage φTX is input to the gate of the transfer transistor TX, which is switched on and off by φTX. The drain of the transfer transistor TX is connected to the FD. By adjusting the voltage of φTX, the transfer transistor TX is driven at the intermediate potential.

The FD accumulates the signal charge transferred from the photoelectric conversion element PD and converts the accumulated signal charge to a voltage signal having a level corresponding to the magnitude of the signal charge.

The reset transistor RST is constituted by an nMOS (negative channel Metal Oxide Semiconductor), for example, and a signal φRST for switching the reset transistor RST on and off is input to the gate, a drive voltage PVDD is input to the drain, and the source is connected to the gate of the amplification transistor SF via the FD.

The reset transistor RST is switched on and off under the control of the row drive unit 2 and resets the FD. The PVDD and PVSS are output from a voltage source, which is not illustrated, and φRST is output from the row drive unit 2.

The amplification transistor SF is constituted by an nMOS, for example, the gate thereof is connected to a transfer transistor TX and a reset transistor RST, via the FD, the drive voltage PVDD is input to the drain, and the source is connected to the row selection transistor SEL. The amplification transistor SF amplifies the pixel signal output from the FD and outputs the signal to the row selection transistor SEL.

The row selection transistor SEL is constituted by an nMOS, for example, and a row selection signal φVSEN is input to the gate thereof, the drain is connected to the amplification transistor SF, and the source is connected to the column ADC of the corresponding column via the vertical signal line L1. The row selection transistor SEL outputs the pixel signal amplified by the amplification transistor SF, to the column ADC of the corresponding column via the vertical signal line L1. Here, φVSEN is output from the row drive unit 2.

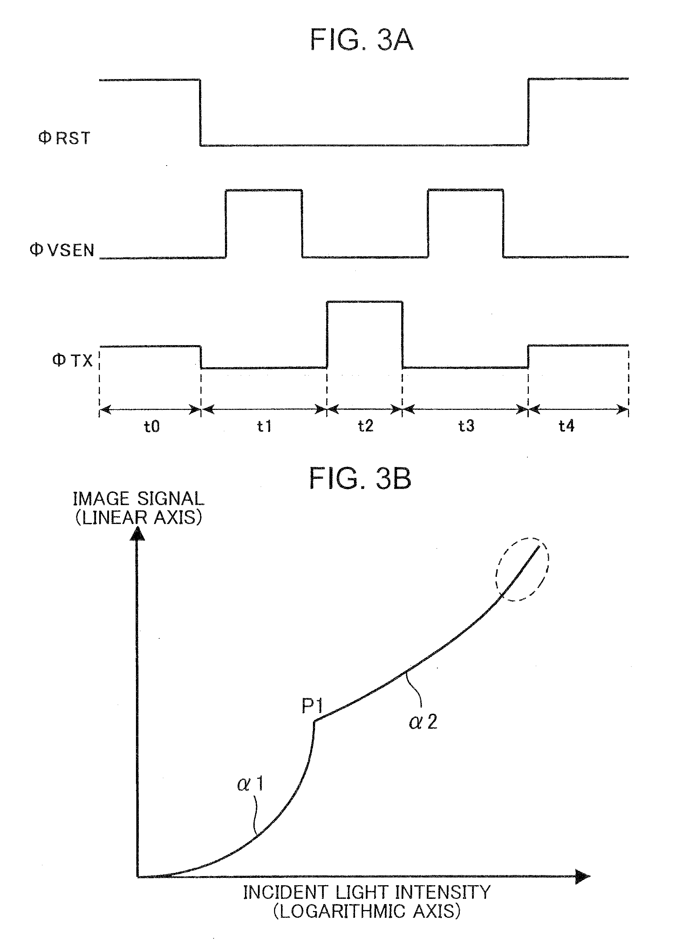

Fig. 3A shows a timing chart of a pixel circuit GC. As shown in Fig. 3A, the pixel circuit GC outputs a pixel signal by cyclically repeating four periods, an exposure period t0, t4, a noise reading period t1, a transfer period t2, and a signal reading period t3.

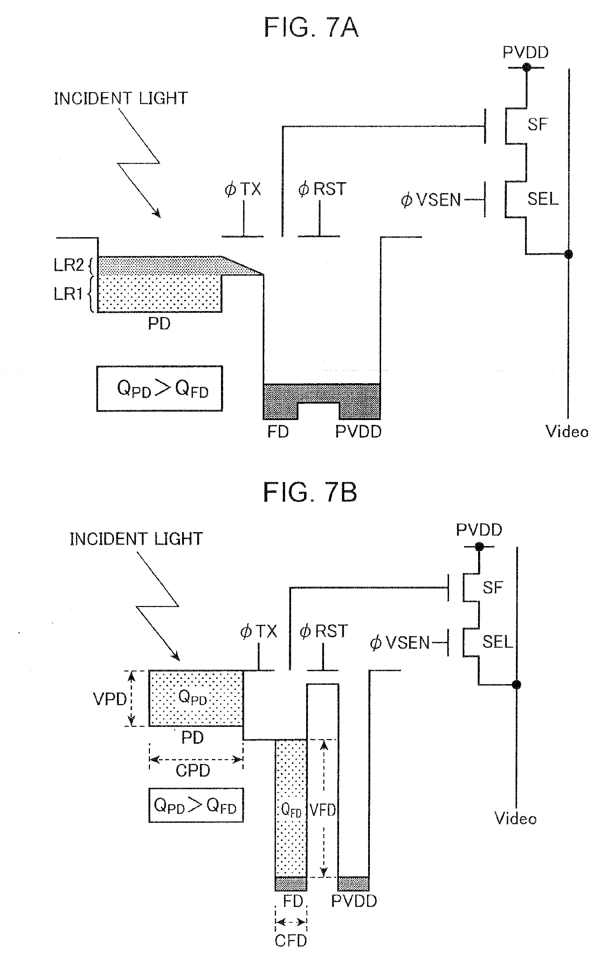

More specifically, the exposure period t0 starts when the signal reading period of the previous frame (not illustrated) ends. In the exposure period t0, φRST is set to Hi to switch the reset transistor RST on, φVSEN is set to Lo to switch the row selection transistor SEL off, and φTX is set to an intermediate potential between Hi and Lo so that the gate of the transfer transistor TX opens by a small amount. By this means, as shown in Fig. 7, signal charge is accumulated linearly in accordance with the amount of light, in the photoelectric conversion element PD, until the signal charge accumulated in the photoelectric conversion element PD exceeds a prescribed value. On the other hand, if the signal charge accumulated in the photoelectric conversion element PD exceeds the prescribed value, then a portion of the signal charge is leaked to the FD while the charge is accumulated in the photoelectric conversion element PD, and therefore the signal charge is accumulated logarithmically in accordance with the amount of light.

Furthermore, in the exposure period t0, φRST is set to Hi, the FD is reset, and therefore the FD eliminates the signal charge which leaks out from the photoelectric conversion element PD. Consequently, in the exposure period t0, the level of the voltage signal in the FD is held at PVDD constantly.

In the noise reading period t1, φRST is set to Lo, φVSEN is set to Hi, φTX is set to Lo, the reset transistor RST is switched off, the row selection transistor SEL is switched on and the transfer transistor TX is switched off.

By this means, when the gate of the transfer transistor TX is closed, a reset level voltage signal in the FD is read out by the amplification transistor SF and the row selection transistor SEL, and is output to the column ADC of the corresponding column, as a noise signal. This noise signal principally includes kTC noise generated when the FD is reset, and varies for each pixel circuit GC.

Here, in the noise reading period t1, the reset level voltage signal in the FD is read out in a state where the FD has not been reset by the reset transistor RST, and therefore it is possible to output a highly accurate noise signal based on the reset level voltage signal of the FD which varies in each pixel circuit GC.

In the noise reading period t2, φRST is set to Lo, φVSEN is set to Lo, φTX is set to Hi, the reset transistor RST is switched off, the row selection transistor SEL is switched off and the transfer transistor is switched on. Consequently, the gate of the transfer transistor TX is fully opened, and the signal charge accumulated in the photoelectric conversion element PD is transferred to the FD.

In the signal reading period t3, φRST is Lo, φVSEN is Hi and φTX is Lo, the signal change is converted to a voltage signal by the FD, and the converted voltage signal is read out by the amplification transistor SF and the row selection transistor SEL, and output to the column ADC of the corresponding column as a noise-plus-image signal.

When the signal reading period t3 has ended, the next exposure period t4 starts, and exposure processing for obtaining an image signal for the next frame is started.

By correlated double sampling, the column ADC which is described below acquires the difference between the noise signal read out in the noise reading period and the noise-plus-image signal read out in the signal reading period, and eliminates the noise component included in the noise-plus-image signal to extract an image signal.

Fig. 3B is a graph showing the photoelectric conversion characteristics of a pixel circuit GC which is driven in accordance with the timing chart in Fig. 3A. In Fig. 3B, the vertical axis is a linear axis which represents an image signal output from the pixel circuit GC, and the horizontal axis is a logarithmic axis which indicates the incident light intensity at the photoelectric conversion element PD.

As this graph reveals, on the low brightness side of an inflection point P1, the circuit has linear characteristics α1 and on the high brightness side thereof, the circuit has logarithmic characteristics α2. In the graph in Fig. 3B, the fact that the linear characteristics α1 increase following a curve and the logarithmic characteristics α2 increase in virtually a straight line is due to the fact that the horizontal axis is a logarithmic axis.

As indicated by the region inside the round dotted frame, the log characteristics α2 change following a curve, rather than a straight line, on the high brightness side, and hence change linearly.

This is because during the noise reading period t1 shown in Fig. 3A, φTX is set to Lo and hence the gate of the transfer transistor TX is completely closed.

In other words, if the transfer transistor TX is completely off during the noise reading period t1, then although the period is called the noise reading period t1, the photoelectric conversion element PD continues exposure, and therefore if the subject is of high brightness, the photoelectric conversion element PD accumulates signal charge linearly.

Therefore, when exposing a subject of high brightness, immediately before the start of the transfer period t2, a signal charge of three layers will have accumulated in the photoelectric conversion element PD, namely, a signal charge accumulated linearly in a lower layer, a signal charge accumulated logarithmically in an intermediate layer and a signal charge accumulated linearly in an upper layer. By this means, the signal charge which has accumulated linearly in the upper layer appears on the high brightness side, as shown in Fig. 3B, and the high brightness side of the log characteristics α2 changes in a linear fashion.

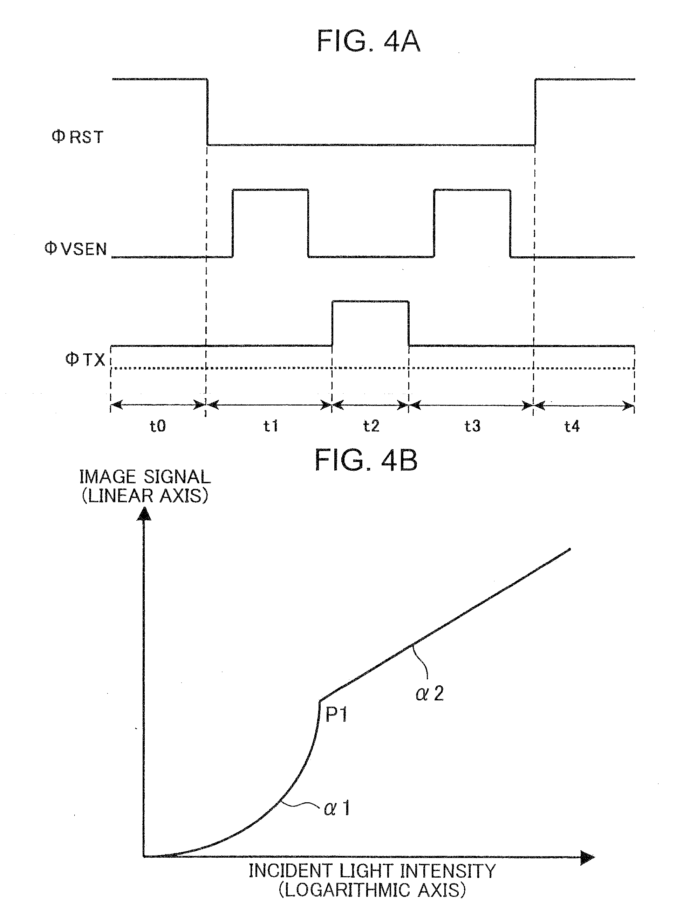

In order to prevent this, desirably, the pixel circuit GC is driven as described below. Fig. 4A is a modification example of a timing chart of the pixel circuit GC shown in Fig. 2. Furthermore, Fig. 4B is a graph showing the photoelectric conversion characteristics when a pixel circuit GC is driven in accordance with the timing chart shown in Fig. 4A. In Fig. 4A, the vertical axis and the horizontal axis are the same as the vertical axis and the horizontal axis shown in Fig. 3A.

The point of difference between the timing chart shown in Fig. 4A and the timing chart shown in Fig. 3A lies in the noise reading period t1 and the signal reading period t3.

More specifically, in the noise reading period t1 shown in Fig. 4A, φTX is set to continue at an intermediate potential, similarly to the exposure period t0. Therefore, when the transfer transistor TX is driven at the intermediate voltage, even though the subject is exposed at a high brightness during the noise reading period t1, the signal charge accumulated in the photoelectric conversion element PD leaks out to the FD and the photoelectric conversion element PD accumulates signal charge logarithmically.

In other words, when a subject of high brightness is exposed, a two-layer signal charge is accumulated in the photoelectric conversion element PD, namely, a signal charge which is accumulated linearly in a lower layer and a signal charge which is accumulated logarithmically in an upper layer. By this means, as shown in Fig. 4B, the log characteristics α2 change in substantially logarithmic fashion on the high brightness side as well, and the appearance of linear characteristics on the high brightness side of the log characteristics α2 such as those shown in Fig. 3B can be suppressed.

Furthermore, in the timing chart in Fig. 4A, in the signal reading period t3, φTX is set to an intermediate potential. By this means, in the signal reading period t3, the transfer transistor TX is driven at the same intermediate potential as the noise reading period t1, and therefore the reset level of the voltage signal in the FD can be made equal in the noise reading period t1 and the signal reading period t3.

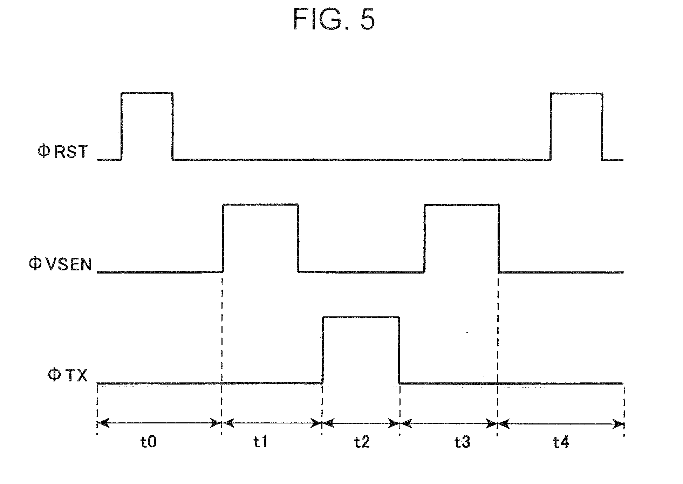

Fig. 5 shows a timing chart when the pixel circuit GC is driven with linear characteristics rather than linear log characteristics. In Fig. 5 also, similarly to Fig. 3A and Fig. 4A, the pixel circuit GC outputs a pixel signal by cyclically repeating four periods, an exposure period t0, a noise reading period t1, a transfer period t2, a signal reading period t3 and an exposure period t4.

In the exposure period t0, φTX is set to Lo, the gate of the transfer transistor TX is completely closed, and therefore the signal charge accumulated in the photoelectric conversion element PD is accumulated linearly rather than leaking out to the FD.

Moreover, in the exposure period t0, since the gate of the transfer transistor TX is completely closed, then the signal charge from the photoelectric conversion element PD to the FD does not leak out. Consequently, φRST is not set to Hi during the whole of the exposure period t0, but rather is only Hi during a portion of the exposure period t0 immediately before the reset level voltage signal is read out from the FD.

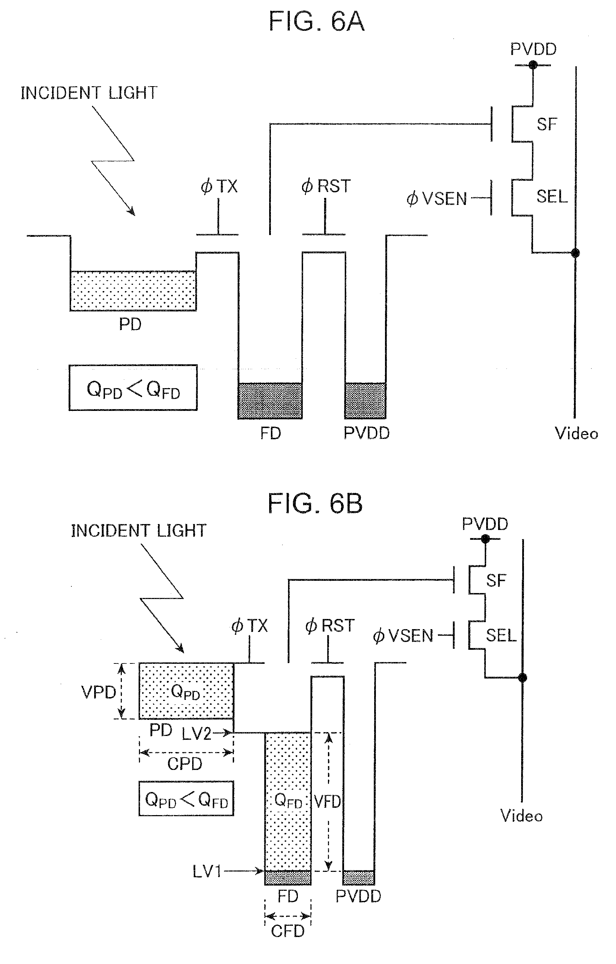

Fig. 6A shows a potential chart of the pixel circuit GC when the pixel circuit GC is driven with linear characteristics. Fig. 6A is a potential chart during an exposure period. In the exposure period, since the gate of the transfer transistor TX is closed, then the signal charge is accumulated linearly with respect to the incident light, in the photoelectric conversion element PD. In Fig. 6A, the pixel circuit GC is designed in such a manner that the saturation charge of the photoelectric conversion element PD (hereinafter, called "QPD") and the operating charge of the FD (hereinafter, called "QFD") establish the relationship QPD < QFD, because all of the signal charge accumulated in the photoelectric conversion element PD must be received in the FD.

Fig. 6B is a potential chart of a pixel circuit GC for describing the QPD and the QFD. As shown in Fig. 6B, the value of QPD is determined by the product of the capacity of the photoelectric conversion element PD (hereinafter, called "CPD") and the voltage amplitude of the photoelectric conversion element PD (hereinafter, called "VPD"), namely QPD = CPD·VPD.

Here, CPD and VPD can be determined by both the design parameters and the manufacturing parameters of the pixel circuit GC, and in the present embodiment, QPD is determined by, for example, adjusting the surface area of the photoelectric conversion element PD to regulate the values of CPD and VPD.

Furthermore, QFD is determined as the product of the capacity of the FD (hereinafter, called "CFD") and the voltage amplitude of the FD (hereinafter, called "VFD"). Here, CFD is determined by both the design parameters and the manufacturing parameters of the FD, and in the present embodiment, CFD is determined by adjusting the surface area of the FD, for example.

Moreover, VFD is specified by the FD reset level LV1, and the potential LV2 on the FD side of the transfer transistor TX when the transfer transistor TX is fully open.

In Fig. 6B, the pixel circuit GC is designed so as to establish QPD < QFD. Here, since CPD < CFD, then QPD < QFD is achieved. In the case of an embedded-type photoelectric conversion element, the sensitivity is chiefly determined by CFD, rather than CPD. Therefore, if the CPD is made larger, CFD must also be made larger, and decline in sensitivity becomes a concern.

In particular, if the size of the pixel circuit GC becomes larger, CPD also becomes larger, and consequently, CFD must also be made larger. If CFD becomes larger, the amount of change in the voltage of the FD in relation to one electron becomes smaller, and hence the charge to voltage conversion coefficient of the FD becomes smaller, there is a decline in the tolerance with respect to noise generated in the pixel circuit GC and subsequent parts, and the S/N ratio becomes worse.

Therefore, in the present embodiment, the pixel circuit GC is designed in such a manner that the relationship QPD > QFD is satisfied. Here, since CPD > CFD, then it is assumed that QPD > QFD is achieved.

Fig. 7A shows a potential chart during an exposure period when a pixel circuit GC designed so as to satisfy the relationship QPD > QFD is driven with linear log characteristics. In the exposure period, φTX is set to an intermediate potential, and therefore if the signal charge accumulates to a prescribed value or greater, the charge leaks from the photoelectric conversion element PD to the FD while accumulating in the photoelectric conversion element PD. Consequently, a two-layer signal charge accumulates in superimposed fashion in the photoelectric conversion element PD, this two-layer signal charge comprising a signal charge LR1 which is accumulated linearly with respect to the incident light and a signal charge LR2 which is accumulated logarithmically with respect to the incident light.

Fig. 7B shows a potential chart during a transfer period when a pixel circuit GC designed so as to satisfy the relationship QPD > QFD is driven with linear log characteristics. The potential charts shown in the present embodiment depict falling potential from the bottom to the top of the chart. As shown in Fig. 7A, since φRST is set to a high potential during the exposure period, then FD is reset by the reset transistor RST and is kept at the potential PVDD at all times. Consequently, during the exposure period, the signal charge which has leaked out from the photoelectric conversion element PD to the FD is eliminated to the PVDD side.

Furthermore, as shown in Figs. 7A and 7B, the width of CFD is designed to be shorter than in Figs. 6A and 6B, and QFD is designed to be smaller than QPD.

Consequently, it is possible to increase the charge to voltage conversion coefficient in comparison with a case where QFD > QPD, and tolerance with respect to noise generated in the pixel circuit GC and subsequent parts is raised, which means that a higher S/N ratio can be achieved.

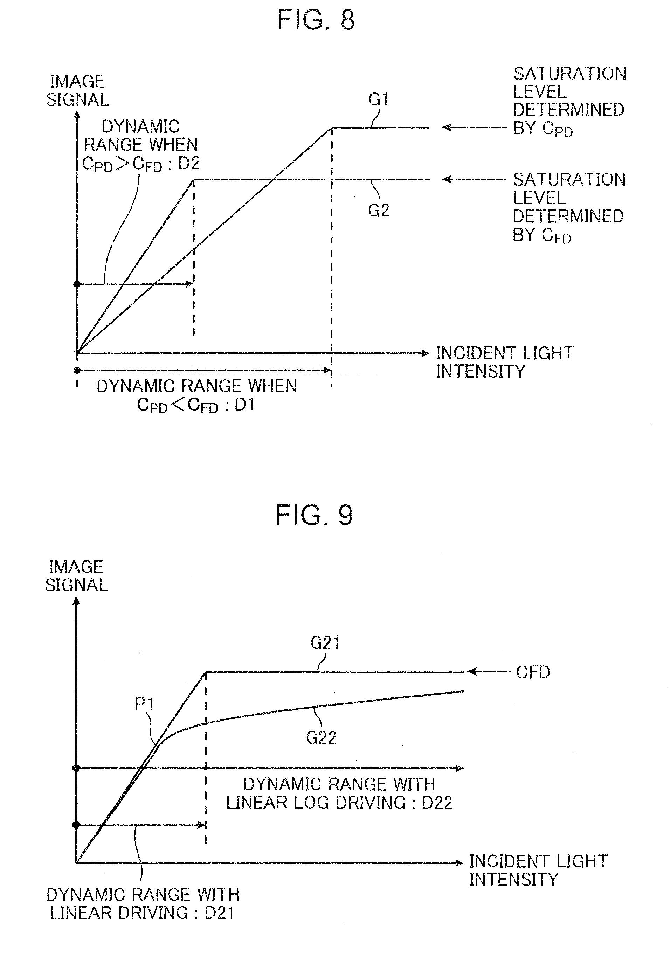

Fig. 8 is a graph showing the photoelectric conversion characteristics of a pixel circuit GC which is driven with linear characteristics, G1 shows the photoelectric conversion characteristics of a pixel circuit GC which is designed so as to satisfy the relationship QPD < QFD, and G2 shows the photoelectric conversion characteristics of a pixel circuit GC which is designed so as to satisfy the relationship QPD > QFD. In Fig. 8, the vertical axis represents an image signal and the horizontal axis represents the incident light intensity.

The gradient of the graph G2 is larger than the gradient of the graph G1, and it can be seen that the sensitivity of the pixel circuit GC which is designed so as to satisfy the relationship QPD > QFD, in other words, CPD > CFD, is greater than the sensitivity of the pixel circuit GC which is designed so as to satisfy the relationship QPD < QFD, in other words, CPD < CFD.

Here, the saturation level of the pixel circuit GC which satisfies the relationship QPD > QFD is determined by CFD, as indicated by G2. Furthermore, the saturation level of the pixel circuit GC which satisfies the relationship QPD < QFD is determined by CPD, as indicated by G1.

Therefore, the dynamic range D2 when the pixel circuit GC is designed so as to satisfy QPD > QFD, in other words, CPD > CFD, is narrow compared to the dynamic range D1 when the pixel circuit GC is designed so as to satisfy QPD < QFD, in other words, CPD < CFD.

In the case of G2, the pixel circuit GC is designed in such a manner that CPD > CFD, and therefore the FD cannot receive all of the signal charge generated in the photoelectric conversion element PD. Therefore, the saturation level is determined by CFD in the pixel circuit GC where QPD > QFD.

Consequently, if the pixel circuit GC is driven with linear characteristics, then it is possible to raise the sensitivity when CPD > CFD, but at the same time, this leads to decline in the dynamic range.

However, the pixel circuit GC according to the present embodiment is driven with linear log characteristics. Fig. 9 is a comparison chart of the photoelectric conversion characteristics when a pixel circuit GC which satisfies the relationship CPD > CFD is driven with linear log characteristics and when the same circuit is driven with linear characteristics.

In Fig. 9, G21 indicates the photoelectric conversion characteristics when the pixel circuit GC is driven with linear characteristics and G22 indicates the photoelectric conversion characteristics when the pixel circuit GC is driven with linear log characteristics.

In both G21 and G22, the circuit is set up in such a manner that CPD > CFD, and therefore the sensitivity in the low brightness region displays the same linear characteristics in both cases, and it can be seen that higher sensitivity is achieved compared to G1 in Fig. 8. In G21, the circuit only has linear characteristics, and therefore the image signal level soon reaches a saturation level determined by CFD, and it can be seen that the dynamic range D21 becomes narrower. On the other hand, in G22, the characteristics change from linear characteristics to log characteristics at the inflection point P1, and therefore the level of the image signal does not immediately reach the saturation level determined by CFD, but rather has a broad dynamic range D22.

Consequently, even if the sensitivity is raised by CPD > CFD, then it is possible to broaden the dynamic range D22 of the pixel circuit GC by driving with linear log characteristics.

In this way, even when CPD > CFD, if the pixel circuit GC is driven with linear log characteristics, it is possible to achieve a broad dynamic range, while maintaining high sensitivity in the low brightness region. In other words, by reducing the value of CFD and driving with linear log characteristics, it is possible both to improve the sensitivity in the low brightness region and also to broaden the dynamic range.

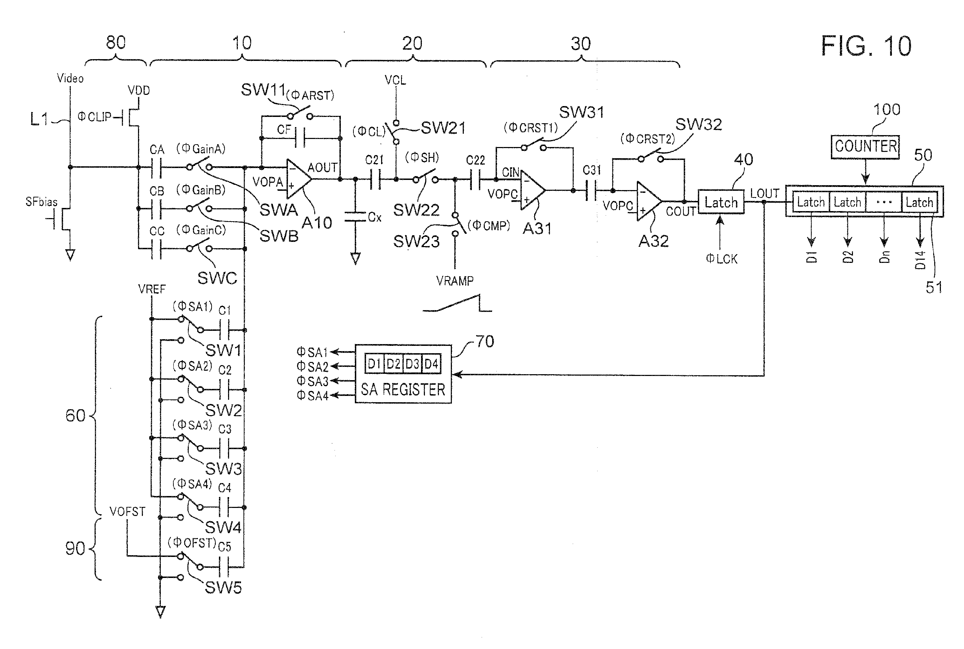

Fig. 10 shows a circuit diagram of one column ADC which constitutes a column ADC array unit 3 shown in Fig. 1. The column ADC comprises a column amp 10 (correlated double sampling unit), a clamp unit 20, a comparator unit 30, a LCK latch circuit 40, a latch unit 50, a progressive comparative signal generation unit 60, a SA register 70, a noise level limiting transistor 80 and a dark current removing unit 90.

In Fig. 10, φGainA, φGainB, φGainC, φARST, φCL, φSH, φCMP, φCRST1, φCRST2 are control signals which are output from the timing generator 6, for example. Furthermore, VRAMP indicates a ramp signal, which is output from the ramp generator 9.

The column amp 10 applies amplification processing to the pixel signal Video which is output from the pixel array unit 1, while performing a correlated double sampling process, and removes a noise signal from the pixel signal Video.

More specifically, the column amp 10 comprises an operational amplifier A 10, capacitors CA, CB, CC, CF and switches SWA, SWB, SWC, SW11. The capacitors CA, CB, CC are connected to the negative terminal side of the operational amplifier A10, via the switches SWA, SWB and SWC. The capacitor CF is a feedback capacitor which is provided between the input and output terminals of the operational amplifier A10.

The switch SWA is a switch for connecting the capacitor CA to the operational amplifier A10, and when φGainA = Hi, for example, the switch SWA turns on to connect the capacitor CA to the negative terminal of the operational amplifier A10, whereas when φGainA = Lo (low level), the switch SWA turns off to cut off the capacitor CA from the negative terminal of the operational amplifier A10. Similarly to the switch SWA, the switches SWB and SWC are switches for connecting the capacitors CB, CC to the operational amplifier A10.

The switch SW11 is connected in parallel to the capacitor CF and switches on when φARST = Hi, and switches off when φARST = Lo, whereby the column amplifier 10 is reset, and the potential at the negative terminal of the operational amplifier A10 and the output terminal of the operational amplifier A10 is set to a prescribed reset level (hereinafter, called "VOPA"). VOPA is applied to the positive terminal of the operational amplifier A10 at all times.

Here, the column amplifier 10 amplifies the input signal by a gain of CA/CF when switch SWA is on, amplifies the input signal by a gain of CB/CF when the switch SWB is on, amplifies the input signal by a gain of CC/CF when the switch SWC is on, and amplifies the input signal by a gain of (CA+ CB + CC) / CF when the switches SWA, SWB, SWC are on.

The clamp unit 20 is provided on the output terminal side of the column amplifier 10, and the black level of the signal AOUT which is output from the column amplifier 10 is fixed to a clamp voltage VCL, which is a prescribed fixed voltage. Here, the clamp unit 20 comprises switches SW21, SW22 and capacitors C21, C22. One end of the switch SW21 is earthed via the capacitors C21, Cx, and is also connected to the output terminal of the operational amplifier A10 via the capacitor C21, and the other end of the switch SW21 is connected to a clamp voltage source (not illustrated) which outputs a clamp voltage VCL. The switch SW21 turns on when φCL = Hi and turns off when φCL = Lo.

One end of the switch SW22 is connected to the capacitor C21 and the other end thereof is connected to the comparator unit 30 via the capacitor C22. The switch SW22 turns on when φSH = Hi and connects the column amplifier 10 and the comparator unit 30, and turns off when φSH = Lo, and disconnects the column amplifier 10 and the comparator unit 30.

One end of the capacitor Cx is connected to the capacitor C21 and the other end is earthed and holds AOUT.

The comparator unit 30 comprises switches SW31, SW32, a comparator C31, and comparators A31, A32.

The switch SW23 is connected to the negative terminal of the comparator A31 via the capacitor C22, and VRAMP is input to the other end of the switch SW23, which turns on when φCMP = Hi and inputs VRAMP to the negative terminal of the comparator A31, and which turns off when φCMP = Lo and does not input VRAMP to the negative terminal of the comparator A31.

In the present embodiment, the image signal is AD converted by dividing into a high order bit group of 4 high order bits and a low order bit group of 10 low order bits. The column ADC performs AD conversion of the high order bit group by using a sequential comparison type of AD conversion method, and performs AD conversion of the low order bit group by using an integration type of AD conversion method.

Therefore, VRAMP employs a ramp signal which increases linearly over time in a range of 0 to 1023 (= 2¹⁰), for instance, in order to perform AD conversion of the low order bit group.

The switch SW31 is connected between the input and output terminals of the comparator A31 and switches on when φCRST1 = Hi, and switches off when φCRST1 = Lo, whereby the comparator A31 is reset, and the potential at the negative terminal of the comparator A31 and the output terminal of the comparator A31 is set to a prescribed reset level (hereinafter, called "VOPC"). VOPC is applied to the positive terminal of the comparator A31 at all times.

The comparator A31 compares the signal input to the negative terminal (hereinafter called "CIN") with VOPC, and inverts the output signal to a low level, if CIN is greater than VOPC, or inverts the output signal to a high level if CIN is lower than VOPC.

The switch SW32 is connected between the input and output terminals of the comparator A32 and switches on when φCRST2 = Hi, and switches off when φCRST2 = Lo, whereby the comparator A32 is reset, and the potential at the negative terminal of the comparator A32 and the output terminal of the comparator A32 is set to the prescribed reset level, VOPC. VOPC is applied to the positive terminal of the comparator A32 at all times.

The negative terminal of the comparator A32 is connected to the comparator A31 via the capacitor C31, and if the output signal from the comparator A31 is greater than VOPC, then the output signal (hereinafter, called "COUT") is inverted to Lo, whereas if the output signal from the comparator A31 is lower than VOPC, then COUT is inverted to Hi.

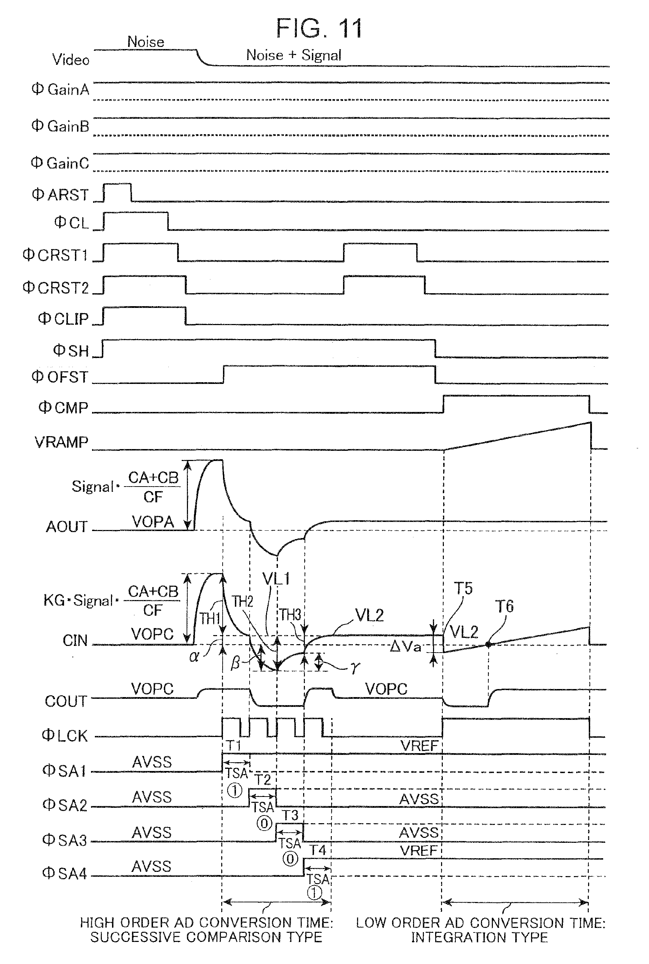

The LCK latch circuit 40 is a one-bit latch circuit for specifying a bit value of the high order bit group (= D1 to D4). More specifically, as shown in Fig. 11, the LCK latch circuit 40 inputs φLCK which has a shorter Hi period than TSA, which is the period for specifying one bit value of the high order bit group, and detects the presence or absence of inversion of COUT while φLCK is Hi: if COUT has been inverted, then the currently latched value is inverted and if COUT has not been inverted, then the currently latched value is not inverted. If φLCK has switched to Lo, for example, then the LCK latch circuit 40 outputs the currently latched bit value as LOUT, which is latched in the latch circuit 51 of the corresponding bit, in the next stage of the circuitry.

For example, the LCK latch circuit 40 latches a value of 1 by default, and if VOPC has not been inverted in the first TSA period for specifying D1, a value of 1 is latched in the latch circuit 51 for D1, whereas if VOPC has been inverted, then a value of 0 is latched in the latch circuit 51 for D 1.

Furthermore, if VOPC is not inverted in the second TSA period for specifying D2, and the LCK latch circuit 40 has latched a value of 1, then a value of 1 is latched in the latch circuit 51 for D2, whereas if the LCK latch circuit 40 has latched a value of 0, then 0 is latched in the latch circuit 51 for D2.

On the other hand, if VOPC has been inverted in the second TSA period, and the LCK latch circuit 40 has latched a value of 1, then the value of 1 is inverted to latch a value of 0, and this value of 0 is latched in the latch circuit 51 for D2, whereas if the LCK latch circuit 40 has latched a value of 0, then the value of 0 is inverted to latch a value of 1, and this value of 1 is latched in the latch circuit 51 for D2. The LCK latch circuit 40 specifies bit values in a similar fashion for D3 and D4.

Next, the reason for providing the LCK latch circuit 40 will be described. If the LCK latch circuit 40 is not provided, then the problems described below arise.

The values of the high order bits, D1 to D4, are set by sequential comparison, but if there is no major difference in size between CIN and VOPC which are input to the comparator unit 30, then a situation may occur where COUT changes at the end of a TSA period.

The capacitive load from the output terminal of the comparator A32 to the latch unit 50 is not equal to the capacitive load from the output terminal of the comparator A32 to the SA register 70. In Fig. 10, the wiring length from the output terminal of the comparator A32 to the SA register 70 is greater than the wiring length from the output terminal of the comparator A32 to the latch unit 50, and therefore the capacitive load is larger and the propagation delay is greater.

In a case where COUT is inverted from Hi to Lo at the end of a TSA period, if there is no LCK latch circuit 40, then the inversion of COUT is propagated to the latch unit 50, but is not propagated to the SA register 70, because the capacitive load between the comparator A32 and the latch unit 50 is smaller than the capacitive load between the comparator A32 and the SA register 70.

By this means, for example, a situation arises where 0 is latched for D1 in the latch unit 50, but 1 is latched for D1 in the SA register 70, and although the SA register 70 and the latch unit 50 are meant to latch the same values, they in fact latch different values.

The data latched in the latch unit 50 is the data that is output externally as a pixel signal, and therefore in the case described above, 0 is output, although a value of 1 is latched in the SA register 70. Therefore, in the column ADC, processing is carried out assuming D1 = 1 and the capacitors C1 to C4 connected to the column amplifier 10 are set accordingly, but since the pixel signal output externally is 0, then there is a risk that noise in the form of black dots will be observed in the output image. In other words, a value of 0 is output at points where a value of 1 should be output, and hence there is a possibility of "black dot noise" which is smaller and darker than the peripheral area, appearing in the output image.

Furthermore, if, conversely to the case described above, COUT is inverted from Lo to Hi at the end of a TSA period, and a value of 0 is latched in SA register 70, whereas a value of 1 is latched in the latch unit 50, then "white dot noise" which is smaller and brighter than the peripheral area is observed in the output image.

The LCK latch circuit 40 is provided in order to resolve the problems described above. In other words, the LCK latch circuit 40 is driven by φLCK, and as shown in Fig. 11, since φLCK is a pulse signal having a slightly shorter Hi period than TSA, then inversion of COUT at the end of a TSA period is not propagated to the SA register 70 and the latch unit 50, in such a manner that the same value can be latched in the latch unit 50 and the SA register 70. As a result of this, it is possible to prevent the appearance of the black dot noise or white dot noise described above in the output image.

The latch unit 50 comprises 14 latch circuits 51 which latch the bit values of the high order bit group (= D1 to D4) and the bit values of the low order bit group (= D5 to D14).

The counter 100 is constituted by a 10-bit counter which is provided inside the timing generator 6 shown in Fig. 1, for example, and counts the time from the start of input of VRAMP to the comparator unit 30 until CIN reaches VOPC and COUT is inverted. The counter 100 latches the count value in the 10 latch circuits 51 which latch D5 to D 14.

The sequential comparison signal generation unit 60 comprises capacitors C1 to C4 as sequential comparison capacitors, and switches SA1 to SA4. The capacitors C1 to C4 correspond to the respective bits of the high order bit group, and respectively output signals of different levels to the column amplifier 10. More specifically, one end of each of the capacitors C1 to C4 is connected to a voltage source (not illustrated) which outputs a reference voltage (hereinafter called "VREF") via the switches SA1 to SA4, and the other end thereof is connected to the negative terminal of the operational amplifier A10.

In the present embodiment, the capacitors C1 to C4 respectively correspond to D1 to D4, if the bits of the high order bit group are taken as D1 to D4 sequentially from the highest order bit.

Here, if the dynamic range of KG·Signal·((CA+CB+CC)/CF) is taken as W (where KG = C21/(C21 + C22)), then the capacitances of the capacitors C1 to C4 are respectively set to KG·(C1/CF)·VREF = W/2, KG·(C2/CF)·VREF = W/4, KG·(C3/CF)·VREF = W/8, and KG·(C4/CF)·VREF = W/16.
If the threshold values which specify a value of 1 or 0 for D1 to D4 are respectively taken as TH1 to TH4, then TH1 = W/2, TH2 = W/4, TH3 = W/8 and TH4 = W/16.

The switches SW1 to SW4 respectively connect C1 to C4 to VREF when φSA1 to φSA4 = Hi, and connect C1 to C4 to an earth terminal (Ground) when φSA1 to φSA4 = Lo. Here, φSA1 to φSA4 are output by the SA register 70.

The SA register 70 sequentially switches the connection relationship between the capacitors C1 to C4 and the column amplifier 10, and specifies the values of the high order bits of the image signal (D1 to D4) by a sequential comparison type AD conversion method, on the basis of LOUT which is output by the comparator unit 30.

Here, the SA register 70 connects the capacitors C1 to C4 sequentially to the column amplifier 10 in order from higher to lower capacitance, and specifies whether or not to maintain the connection of a capacitor with the column amplifier 10, as well as specifying the value of the bit corresponding to that capacitor, on the basis of whether or not LOUT is inverted while that capacitor, of the capacitors C1 to C4, is connected to the column amplifier 10.

More specifically, the SA register 70 connects the capacitor C1 to the column amplifier 10, and if LOUT is not inverted, latches D1 = 1 and maintains φSA1 = Hi.
On the other hand, if the SA register 70 connects the capacitor C1 to the column amplifier 10, and LOUT is inverted, then the SA register 70 latches D1 = 0 and switches φSA1 to Lo.

The SA register 70 then sequentially connects the capacitors C2 to C4 to the column amplifier 10, and if LOUT is inverted while any one of the capacitors is connected, latches the value of the bit corresponding to that capacitor, as the inverse of the value of the bit one place higher in the bit order. If SA register 70 has latched a value of 1 as the bit corresponding to this capacitor, then the connection of the capacitor with the column amplifier 10 is maintained, whereas if the SA register 70 has latched a value of 0 as the bit corresponding to the capacitor, then the connection of the capacitor with the column amplifier 10 is shut off.

In other words, the SA register 70 operates similarly to the LCK latch circuit 40 and turns the switches SW1 to SW4 on and off in accordance with the latched values of D1 to D4.

The noise level limiting transistor 80 is constituted by an nMOS transistor, for example, in which a drive signal φCLIP is input to the gate, VDD is input to the drain, and the source is connected to the input side of the column amplifier 10. As shown in Fig. 11, the noise level limiting transistor 80 is driven by φCLIP which is set to an intermediate potential during the noise reading period, and suppresses a white/black reversal effect which occurs when exposing a subject of very high brightness.

Here, the white/black reversal effect is an effect which arises when the FD is not reset correctly when exposing a subject of very high brightness, the level of a noise signal which should have a high potential declines, the image signal obtained by correlated double sampling falls, and a subject of very high brightness which should be reproduced brightly is reproduced darkly.

In the noise reading period, even if the transfer transistor TX is completely off or is driven at an intermediate potential, the photoelectric conversion element PD continues exposure, and therefore a signal charge flows into the FD from the photoelectric conversion element PD if a subject of very high brightness is being exposed. In this case, the level of the noise signal read out in the noise reading period is much lower than the expected level. Consequently, when correlated double sampling is carried out using a noise signal with a reduced level in this way, the subject of very high brightness is reproduced darkly, and a white/black reversal effect occurs.

Here, φCLIP is output from the timing generator 6 and rather than becoming completely Hi, drives the noise level limiting transistor 80 at an intermediate potential which is specified in accordance with a set value previously stored in a register in the timing generator 6. φCLIP is generated by converting the set value stored in the register of the timing generator 6 shown in Fig. 1, to an analog signal, in the DAC 7.

If φCLIP is set fully to Hi, then the noise signal assumes the level of VDD, the noise signal is read out without fully considering the reset level of the FD, and the column amplifier 10 becomes unable to perform the correlated double sampling process. Therefore, by setting the pulse height of φCLIP to an intermediate potential which is lower than the Hi level, it is possible to input a noise signal that takes account of the FD reset level, to the column amplifier 10.

Here, the pulse height of φCLIP is set to a predetermined level at which a high level noise signal that is output from the pixel circuit GC when exposing a subject in a normal brightness range which would not give rise to a white/black reversal effect is not reset by the noise level limiting transistor 80, but at which a low level noise signal that is output from the pixel circuit GC when exposing a subject of very high brightness which would give rise a white/black reversal effect is reset by the noise level limiting transistor 80. In other words, if the level of the noise signal is equal to or greater than a prescribed value, then the noise signal is input directly to the column amplifier 10, and if the level of the noise signal is equal to or lower than the prescribed value, then the level of the noise signal is raised by the noise level limiting transistor 80 and then input to the column amplifier 10.

By this means, rather than using a reduced noise signal in the case of very high brightness, a noise signal of high potential which has been raised to a prescribed value by the noise level limiting transistor 80 is used, and therefore it is possible to suppress a white/black reversal effect which is produced by the correlated double sampling process.

A composition can be adopted in which a plurality of set values are prepared, and the intermediate potential for driving the noise level limiting transistor 80 can be chosen appropriately in such a manner that a suitable set value is selected from the plurality of set values, in accordance with the brightness of the subject, for example.

The dark current removing unit 90 inputs an offset signal for removing the dark current component included in the noise-plus-image signal, to the column amplifier 10, during the signal reading period. Here, the dark current removing unit 90 comprises a switch SW5 and a capacitor C5. A control signal VOFST for generating an offset signal is input to one end of the switch SW5 and the other end of the switch SW5 is connected to the negative terminal of the operational amplifier A10 via the capacitor C5.

Here, VOFST is generated by converting the set value set by the timing generator 6 to an analog signal in the DAC 7. Furthermore, φOFST is output to the column ADC via the DAC 7 under the control of the timing generator 6.

When the dark current of the photoelectric conversion element PD is increased due to an increase in the ambient temperature of the image array unit 1, then a dark current component is included in the noise component of the noise-plus-image signal and the level of the noise component of the noise-plus-image signal is reduced by an amount corresponding to the dark current, compared to the noise signal. Here, the dark current component is not included in the noise signal because the gate of the transfer transistor TX is closed during the noise reading period and the signal charge produced by the dark current does not flow into the FD from the photoelectric conversion element PD. Therefore, despite the fact that a dark subject is being exposed, the dark subject is reproduced brightly in the output image.

For example, if the input range of the pixel signal input to the column ADC is 1.0 V, then if the dark current component is 0.2 V, the image signal must be A/D converted using the remaining 0.8 V. Therefore, in the dark current removing unit 90, the dark current component is subtracted from the noise-plus-image signal before carrying out correlated double sampling, and the full input range of the pixel signal is utilized successfully even when the dark current component has increased.

As shown in Fig. 11, φOFST is Hi from the start time of the high order A/D conversion time in the signal reading time (Noise + Signal) to time T5 where input of VRAMP is started.

When φOFST becomes Hi, then the switch SW5 turns on and the potential at the negative terminal of the operational amplifier A10 rises by VOFST·(C5/CF). When the potential at the negative terminal of the operational amplifier A10 increases, the potential AOUT at the output terminal of the operational amplifier A10 falls by VOFST·(C5/CF).

To give a simple description of the operation of the dark current removing unit 90, the operation of removing a dark current component from AOUT is performed by holding AOUT down continuously while φOFST is Hi.

In this way, it is possible to remove the dark current component from the noise-plus-image signal, by means of VOFST, C5 and CF. Here, the dark current removing unit 90 is connected to the input side of the column amplifier 10, and processes the analog noise-plus-image signal before A/D conversion. Therefore, even if the dark current component is 0.2 V as described above, it is possible to eliminate the 0.2 V loss of input range of the pixel signal, by adjusting VOFST so as to offset the 0.2 V dark current component from the noise-plus-image signal.

The timing generator 6 should establish a set value for specifying VOFST in accordance with the temperature data detected by the temperature sensor 8. In this case, the value of VOFST corresponding to the temperature data value should be determined by using a predetermined function which specifies the relationship between the temperature and VOFST. Furthermore, the timing generator 6 may be devised so as to drive the dark current removing unit 90 only when, for example, there is an increase in the temperature of the image array unit 1 and the effects of dark current cannot be ignored, and not to drive the dark current removing unit 90 in other circumstances.

Next, the operation of the column ADC shown in Fig. 10 will be described. Fig. 11 is a timing chart showing operation of the column ADC. In the timing chart described below, it is assumed that SWA and SWB are on, that the capacitors CA, CB are connected to the operational amplifier A10, and that the capacitor CC is not connected to the operational amplifier A10.

Firstly, when the noise signal Noise from the pixel circuit GC is output as a pixel signal Video to the vertical signal line L1, then φARST, φCL, φCRST1, φCRST2, φCLIP and φSH are set to Hi for a prescribed period, and the column amplifier 10, the clamp unit 20 and the comparator unit 30 are reset.

Next, the noise signal Noise is sampled held by the capacitors CA and CB.

Thereupon, a noise-plus-image signal (Noise + Signal) is output as a pixel signal Video from the pixel array unit 1 and via the vertical signal line L1.

Here, the noise-plus-image signal has a potential which is lower than the noise signal by an amount corresponding to the image component included in the noise-plus-image signal. When the pixel signal Video falls by the image component, the output signal AOUT from the column amplifier 10 increases by Signal·((CA + CB) / CF) from VOPA, in accordance with the magnitude of the image component (Signal).

Furthermore, since the gain KG of the clamp unit 20 is KG = C21/(C21+C22), then CIN increases from VOPC by the amount, KG·Signal·((CA+CB)/CF). In this case, the comparator unit 30 inverts COUT to Hi, since CIN > VOPC.

Next, φSA1 becomes Hi, the capacitor C1 is connected to the column amplifier 10, the potential input to the column amplifier 10 is increased by VREF·C1, and AOUT falls by VREF·(C1/CF). Accordingly, CIN falls by KG·VREF·(C1/CF) = TH1 and assumes a level VL1 (period T1).

In this case, the SA register 70 maintains φSA1 = Hi and latches D1 = 1, because CIN > VOPC and COUT is not inverted (period T1). In other words, the SA register 70 compares the initial CIN (= KG·Signal·(CA+CB)/CF) with the threshold value of D1, which is TH1 (= KG·VREF·(C1/CF)), and since CIN > TH1, then the SA register 70 maintains φSA1 = Hi and sets D1 = 1.

Furthermore, while φLCK is Hi during period T1, the LCK latch circuit 40 latches 1 because CIN > VOPC and COUT is not inverted. Therefore, the latch circuit 51 for D1 latches 1 because 1 is latched in the LCK latch circuit 40. Consequently, D1 is set to D1 = 1.

Thereupon, φSA2 is set to φSA2 = Hi while φSA1 is Hi, and the capacitor C2 is connected to the column amplifier 10. By this means, CIN falls from level VL1 by the amount KG·VREF·(C2/CF) = TH2, CIN becomes smaller than VPOC, COUT is inverted from Hi to Lo, and therefore the SA register 70 returns φSA2 to Lo, disconnects the capacitor C2 from the column amplifier 10, and latches D2 = 0 (period T2).

In other words, the SA register 70 compares α (= initial CIN - TH1) which is obtained by subtracting TH1 from the initial CIN for the period T1, with the threshold value of D2, which is TH2 (= KG·VREF·(C2/CF)) and since the initial CIN - TH1 < TH2, then the SA register 70 returns φSA2 to Lo and latches D2 = 0.

Furthermore, while φLCK is Hi during period T2, the LCK latch circuit 40 latches D2 = 0 because CIN < VOPC and COUT is inverted. Therefore, the latch circuit 51 for D2 latches 0 because 0 is latched in the LCK latch circuit 40. Consequently, D2 is set to D2 = 0.

Next, the SA register 70 sets φSA3 to Hi, while φSA1 = Hi and φSA2 = Lo, and connects the capacitor C3 to the column amplifier 10. By this means, CIN rises to a level which is KG·VREF·(C3/CF) = TH3 lower than the level VL1, but since CIN < VPOC and COUT maintains a Lo level, then the SA register 70 returns φSA3 to Lo and latches D3 = 0 (period T3).

More specifically, the SA register 70 compares P = TH2 - (initial CIN - TH1) and γ (= TH2 - TH3) and since TH2 - (initial CIN - TH1) > TH2 - TH3 means that initial CIN - TH1 < TH3, then the SA register 70 sets D3 as D3 = 0 and returns φSA3 to φSA3 = Lo. TH3 is the threshold value of D3 and is given by TH3 = KG·VREF·(C3/CF).

Furthermore, while φLCK is Hi during period T3, the LCK latch circuit 40 latches D3 = 0 because CIN < VOPC is maintained and COUT is not inverted. Therefore, the latch circuit 51 for D3 latches 0 because 0 is latched in the LCK latch circuit 40. Consequently, D3 is set to D3 = 0.

Next, the SA register 70 sets φSA4 = Hi, while φSA1 = Hi, φSA2 = Lo and φSA3 = Lo, and connects the capacitor C4 to the column amplifier 10. By this means, CIN rises to a level VL2 which is KG·VREF·(C4/CF) lower than the level VL1, but since CIN > VPOC and COUT is inverted from Lo to Hi, then the SA register 70 maintains φSA4 = Hi and latches D4 = 1 (period T4).

More specifically, the SA register 70 compares TH3 - (initial CIN - TH1) and TH3 - TH4 and since TH3 - (initial CIN - TH1) < TH3 - TH4 means that initial CIN - TH1 > TH4, then the SA register 70 sets D4 as D4 = 1 and maintains φSA4 = Hi. TH4 is the threshold value of D4 and is given by TH4 = VREF.(C4/CF).

Furthermore, while φLCK is Hi during period T4, the LCK latch circuit 40 latches D4 = 1 because CIN > VOPC and COUT is inverted. Therefore, the latch circuit 51 for D4 latches 1 because 1 is latched in the LCK latch circuit 40. Consequently, D4 is set to D4 = 1.

By means of the foregoing, the AD conversion period of the high order bit group ends and D1 to D4 are set to D1 to D4 = 1, 0, 0, 1. At this time, CIN which has a level of VL2 is held in the capacitor C22.

Next, φCRST1 and φCRST2 are set to Hi for a certain period, the comparators A31 and A32 are reset, and COUT is set to COUT = VOPC.

Next, φSH is set to φSH = Lo, the comparator unit 30 and the clamp unit 20 are disconnected, φCMP is set to φCMP = Hi, VRAMP is input to the comparator unit 30, VRAMP is superimposed on CIN which has a level VL2 held in the capacitor C22, and CIN is reduced from VL2 by the level ΔVa in accordance with the initial level of VRAMP (time T5). By this means, CIN < VOPC, and COUT is inverted from VOPC to Lo. Furthermore, at time T5, the counter 100 starts a count operation.

Next, if CIN exceeds the level of VOPC (time T6), then COUT is inverted from Lo to Hi. The counter 100 halts the count operation and latches the count value at time T6 in the latch circuits 51 for D5 to D 14. By this means, the values of the respective bits of the low order bit group are specified.

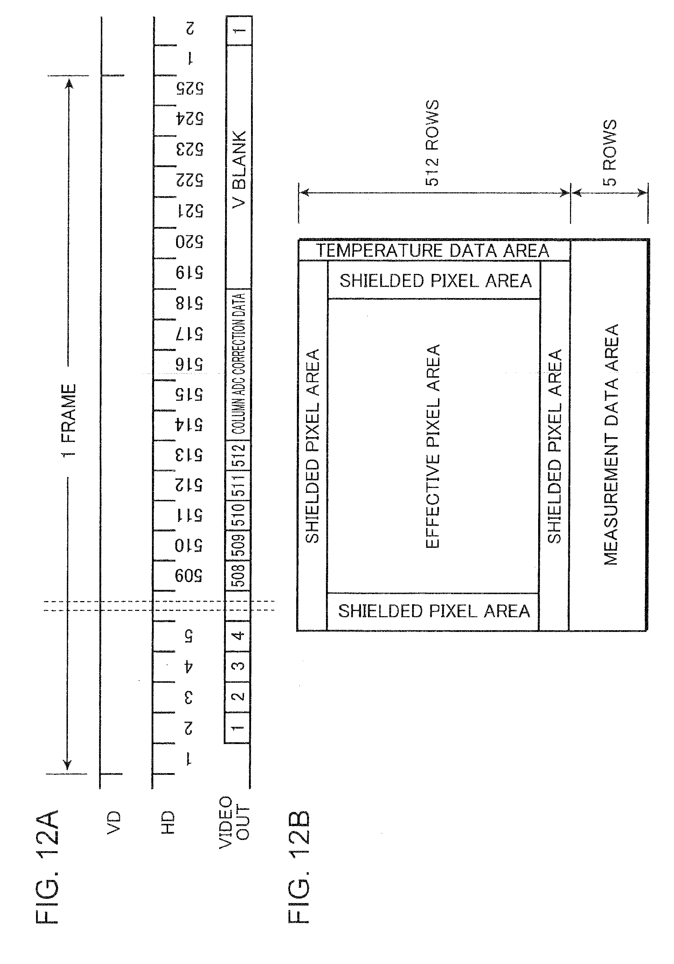

Fig. 12A shows a timing chart of a case where the solid-state imaging device according to an embodiment of the present invention reads out the pixel signal of one frame. In Fig. 12A, one frame is constituted by 512 H periods from period 1H to period 525H. Here, an H period is a time period required to output the image signal for one line from the solid-state imaging device. Furthermore, VD indicates the vertical synchronization signal which specifies the read timing of the image signal of one column, and HD indicates the horizontal synchronization signal which specifies the read timing of the image signal of one row.

If the total number of lines in the image array unit 1 is 512H, then the solid-state imaging device outputs an image signal for 512 rows in the 512 H periods from the H2 period to the 513H period. The remaining 12 H periods from the 514H period to the 525H period are V blank periods, but there is no problem if correctional data of the solid-state imaging device which is unrelated to the subject information is output during this V blank period.

Therefore, in the present embodiment, the 5 H periods from the 514H period to the 518H period are set as a correction data output period for the column ADC.

As shown in Fig. 10, the column ADC performs A/D conversion and removes the dark current component, by comparing the capacitance values of the five capacitors C1, C2, C3, C4, C5 and the capacitor CF. Here, the capacitive value of the capacitors has separate values in the column ADC of each column, and varies between columns.

If the capacitive value of the capacitors varies with each column, then the gain of the column amp 10 varies in each column and the amount of offset by the dark current removing unit 90 varies in each column. In this case, vertical stripe noise, for example, appears in the output image, leading to deterioration in image quality.

Therefore, in the present embodiment, as shown in Fig. 12A, the measurement data used in order to correct the variation in the capacitive values of the capacitors C1 to C5 which constitute the column ADCs of the respective columns is output over the 5 H periods from the 514H period to the 518H period.

More specifically, a fixed voltage source is provided on the input side of the column amplifier 10. In the 514H period, the fixed voltage source inputs a pseudo pixel signal to the column amplifier 10, for connecting only the capacitor C5, of the capacitors C1 to C5, to the column amplifier 10. In this case, the column ADC outputs the value latched in the latch unit 50, as measurement data.

In the 515H period, the fixed voltage source inputs a pseudo pixel signal to the column amplifier, for connecting only the capacitor C4, of the capacitors C1 to C5, to the column amplifier. In this case, the column ADC outputs the value latched in the latch unit 50, as measurement data.

Similarly, the fixed voltage source outputs a pseudo pixel signal to the column ADC so as to connect the column amplifier 10 to the capacitor C3 during the 516H period, to the capacitor C2 during the 517H period, and to the capacitor C1 during the 518H period, and in this case, the column ADC outputs the value latched in the latch unit 50 as measurement data.

The image processing unit 14 can use this measurement data to correct the digital image signal output from the solid-state imaging element so as to eliminate variation in the capacitance values of the capacitors C1 to C5 in each column. Consequently, it is possible to suppress vertical stripe-shaped noise.

Fig. 12B shows an arrangement map in which pixel data which is digital image signal for one pixel output from a solid-state imaging element is arranged as one image, in accordance with the timing chart in Fig. 12A. As shown in the arrangement map, the effective pixel area where the pixel data obtained by exposing the subject is arranged is positioned in the central portion of the map. Shielded pixel areas where pixel data output from shielded pixels is arranged are positioned on the left, right, upper and lower peripheral sides of the effective pixel section. Furthermore, a temperature data area consisting of temperature data output by the temperature sensor 8 is disposed to the outside of the shielded pixel area on the right-hand side, in other words, the rightmost column. The shielded pixel area, the effective pixel area and the temperature data area are positioned in the 1 st to 512nd rows.

In the 5 rows from the 513th row to the 517th row, a measurement data in which measurement data output from the column ADC for each column is arranged is positioned.

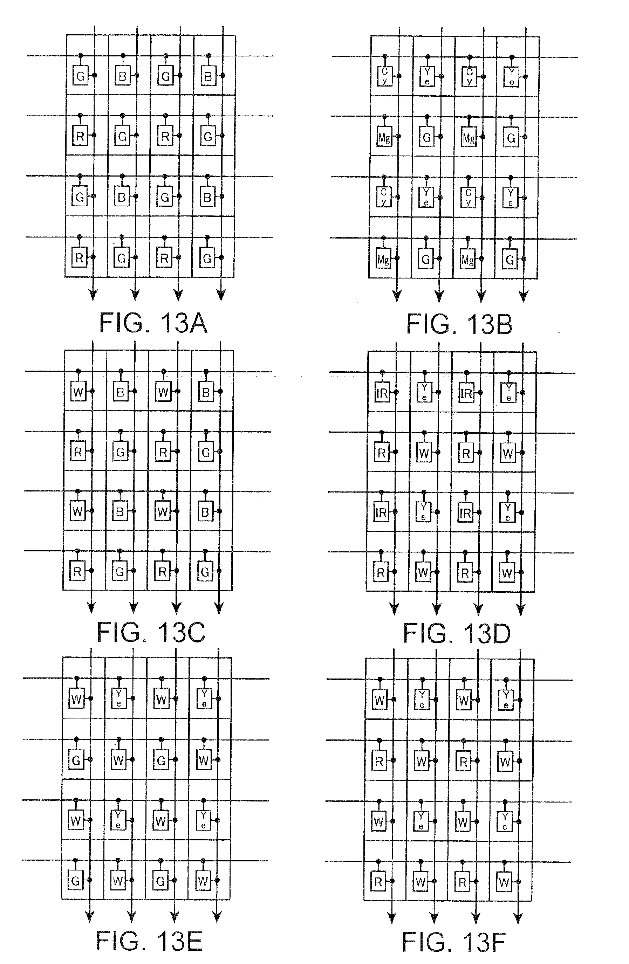

Figs. 13A to 13F show arrangement patterns of color filters which are installed on the pixel circuits GC in the pixel array unit 1. Of course, if color filters are not installed on the pixel array unit 1, the solid-state imaging device becomes a monochrome sensor.

The arrangement pattern in Fig. 13A is an RGB primary color Bayer arrangement. The arrangement pattern in Fig. 13B is a CMY secondary color Bayer arrangement. The arrangement pattern in Fig. 13C is an arrangement pattern in which the color white (W) with no color filter installed is added to the colors R, G, B. Fig. 13D is an arrangement pattern of yellow (Ye), R, infrared (IR) and white (W). Fig. 13E is an arrangement pattern including yellow (Ye), white (W) and G. Fig. 13F is an arrangement pattern including yellow (Ye), white (W) and R.

With an arrangement pattern using infrared light which is not essentially necessary in the case of a color image, as in Fig. 13D, further improvement in sensitivity can be anticipated.

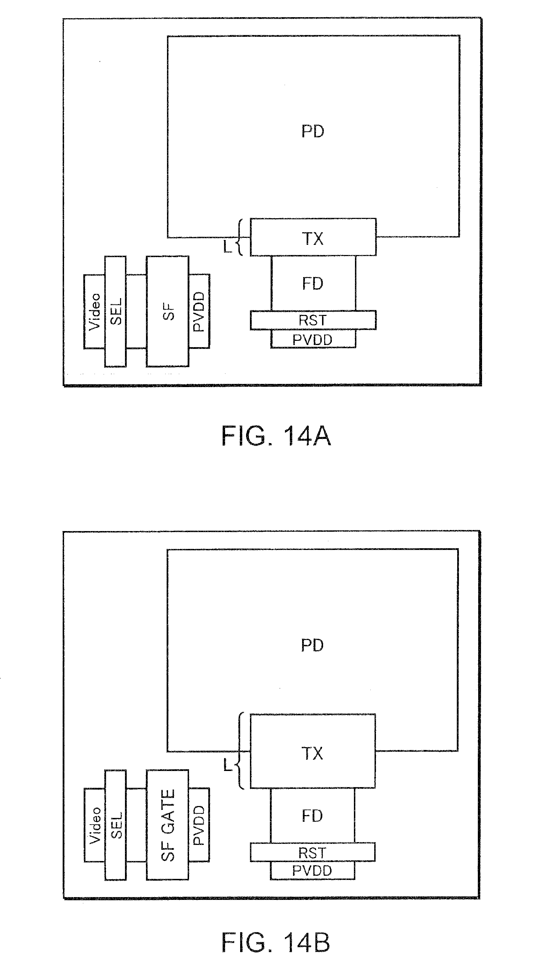

Furthermore, there are the following problems with a CMOS solid-state imaging device which achieves linear log characteristics by driving a transfer transistor TX at an intermediate potential during an exposure period. Fig. 14A shows a pixel circuit GC layout diagram in a comparative example, and Fig. 14B shows a pixel circuit GC layout diagram in the present embodiment.

The pixel circuits GC in a CMOS solid-state imaging device are usually designed so as to shorten the gate length L of the transfer transistor TX, as much as possible, as shown in Fig. 14A, in order to make use of the opening ratio of the light receiving unit. When the gate length is designed to be as short as possible in this way, there is a possibility that a short channel effect will occur. A short channel effect means a phenomenon where the thickness of the depletion layer produced at the source end and the drain end of the channel below the gate is of a size that cannot be ignored in relation to the channel length, so the effective channel length becomes shorter, the transistor switching performance deteriorates, and there is a severe decline in the threshold voltage.

In a pixel circuit GC having linear log characteristics, the sub-threshold characteristics are used as the operating principle. The decline in the switching characteristics of the transfer transistor TX and the fall in the threshold voltage which is produced by the short channel effect have a large effect on the sub-threshold characteristics. Therefore, if the sub-threshold characteristics vary due to manufacturing variations, then the photoelectric conversion characteristics, and in particular, the photoelectric conversion characteristics in the log region, vary greatly between each pixel.

Therefore, as shown in Fig. 14B, the gate length L is designed to be longer, even if this sacrifices the opening ratio of the light receiving unit. Consequently, the occurrence of a short channel effect is suppressed, and variation in the photoelectric conversion characteristics can be reduced.

In this way, according to the solid-state imaging device of the present embodiment, the operating charge of the FD is set to be smaller than the saturation charge of the photoelectric conversion element PD. Consequently, the operational charge of the FD can be reduced, and the charge to voltage conversion coefficient in the FD can be increased, thereby making it possible to improve the sensitivity of the pixel circuit GC.

Moreover, since the pixel circuit GC has photoelectric conversion characteristics including linear characteristics and logarithmic characteristics on either side of a inflection point, then even if the FD operating charge is small, it is possible to suppress reduction in the dynamic range.

The technical features of the solid-state imaging device described above are summarized below.

(1) The solid-state imaging device according to one aspect of the present invention is a solid-state imaging device of CMOS type, comprising a plurality of pixel circuits having photoelectric conversion characteristics including linear characteristics and logarithmic characteristics on either side of an inflection point, wherein the pixel circuits each include: a photoelectric conversion element which accumulates a signal charge by exposing a subject; and a floating diffusion which converts the signal charge accumulated by the photoelectric conversion element into a voltage signal, and the floating diffusion is set to have an operating charge smaller than a saturation charge of the photoelectric conversion element.

According to this composition, the operating charge of the floating diffusion is set to be smaller than the saturation charge of the photoelectric conversion element. Therefore, it is possible to reduce the operating charge of the floating diffusion and increase the charge to voltage conversion coefficient in the floating diffusion, and the sensitivity of the pixel circuit can be improved.

Furthermore, since the pixel circuit has photoelectric conversion characteristics including linear characteristics and logarithmic characteristics on either side of an inflection point, then it is possible to suppress decline in the dynamic range, even if the operating charge of the floating diffusion is reduced. Here, the operating charge indicates the maximum charge which can be accumulated by the floating diffusion.

(2) Desirably, the pixel circuits each include a transfer transistor which transfers the signal charge accumulated by the photoelectric conversion element, to the floating diffusion, and a control unit which drives the transfer transistor at an intermediate potential during an exposure period is also provided.

According to this composition, since the transfer transistor is driven at an intermediate potential during the exposure period, then the signal charge accumulated in the photoelectric conversion element leaks out to the floating diffusion if the signal charge exceeds a prescribed amount. By this means, when exposing a subject of high brightness, the signal charge accumulated in the photoelectric conversion element increases logarithmically in accordance with the amount of light. On the other hand, when exposing a subject of low brightness, the signal charge accumulated in the photoelectric conversion element does not leak out to the floating diffusion side. Consequently, when exposing a subject of low brightness, the signal charge accumulated in the photoelectric conversion element increases linearly in accordance with the amount of light. Therefore, it is possible to achieve a pixel circuit which has linear - log characteristics comprising linear characteristics on a low brightness side of an inflection point and logarithmic characteristics on a high brightness side thereof.

(3) Desirably, a temperature detection unit which detects a temperature of each of the pixel circuits is also provided; and the control unit changes the intermediate potential on the basis of the temperature detected by the temperature detection unit, so as to suppress variation in the inflection point in each of the pixel circuits.

According to this composition, it is possible to suppress variation in the inflection point due to temperature change in the pixel circuit.

(4) Desirably, a plurality of types of the pixel circuits are provided, the control unit generates a predetermined intermediate potential in accordance with the type of pixel circuit, and the transfer transistor is driven by the control unit at an intermediate potential corresponding to the type of pixel circuit to which it belongs.

According to this composition, it is possible to set a desirable inflection point appropriately in accordance with the type of pixel circuit.

(5) Desirably, the pixel circuits each include a reset transistor which resets the floating diffusion; and a row selection transistor which outputs a voltage signal of the floating diffusion as a pixel signal, and the control unit resets the floating diffusion by switching the reset transistor on during an exposure period, and switches the reset transistor off, switches the transfer transistor off and switches the row selection transistor on, during a noise reading period which follows the exposure period.

According to this composition, since the row selection transistor is switched on while the reset transistor and the transfer transistor are off during a noise reading period, then it is possible to read out a different reset level of the floating diffusion for each pixel, accurately, as a noise signal.

(6) Desirably, the pixel circuits each include a reset transistor which resets the floating diffusion; and a row selection transistor which outputs a voltage signal of the floating diffusion as a pixel signal, and the control unit resets the floating diffusion by switching the reset transistor on during an exposure period, and switches the reset transistor off, drives the transfer transistor at the intermediate potential and switches the row selection transistor on, during a noise reading period which follows the exposure period.

According to this composition, in a noise reading period, since the reset transistor is switched off and the transfer transistor is driven at an intermediate potential, then it is possible to prevent the appearance of linear characteristics on the high brightness side in the logarithmic region which is a region having logarithmic characteristics, in the photoelectric conversion characteristics of the pixel circuit. In other words, if the gate of the transfer transistor is completely closed during the noise reading period, then although the period is called the noise reading period, the photoelectric conversion element continues exposure, and therefore if the subject is of high brightness, the photoelectric conversion element accumulates signal charge linearly. On the other hand, if the transfer transistor is driven at an intermediate potential during the noise reading period, then even if a subject of high brightness is exposed in the noise reading period, the signal charge accumulated in the photoelectric conversion element leaks out to the floating diffusion, and the photoelectric conversion element is able to accumulate the signal charge logarithmically. Therefore, it is possible to achieve linear characteristics on the high brightness side of the logarithmic region, in the photoelectric conversion characteristics of the pixel circuit.

(7) Desirably, the control unit switches the transfer transistor on so as to transfer the charge accumulated in the photoelectric conversion element, to the floating diffusion, during a transfer period which follows the noise reading period, and drives the transfer transistor at the intermediate potential and switches the row selection transistor on, during a signal reading period following the transfer period.

According to this composition, since the transfer transistor is driven at the same intermediate potential as the noise reading period, during the signal reading period also, then it is possible to make the reset level of the voltage signal in the floating diffusion the same, during the noise reading period and the signal reading period.

(8) Desirably, the pixel circuits constitute a pixel array unit arranged in a matrix of a prescribed number of rows and a prescribed number of columns, the solid-state imaging device further comprises: a vertical scanning unit which sequentially selects rows of the pixel array unit; and a plurality of reading units which are provided so as to correspond to columns of the pixel unit, read out a pixel signal from the pixel circuit of the row selected by the vertical scanning unit and convert the pixel signal from analog to digital, and the reading units each include: a correlated double sampling circuit which eliminates a noise component from a noise-plus-image signal which is a pixel signal output from each of the pixel circuits during the signal reading period, by subtracting the noise-plus-image signal from a noise signal which is a pixel signal output from each of the pixel circuits during the noise reading period; and a dark current removing unit which inputs an offset signal for removing a dark current component included in the noise-plus-image signal, into the correlated double sampling circuit, during the signal reading period.

According to this composition, a dark current component caused by dark current in the photoelectric conversion element which is included in the noise-plus-image signal output during the signal reading period but is not included in the noise signal output during the noise reading period, is removed, and therefore it is possible to eliminate a noise component accurately in a correlated double sampling circuit.

(9) Desirably, the reading circuits each include a noise level limiting transistor connected to an input terminal of the correlated double sampling circuit, and the control unit drives the noise level limiting transistor at a prescribed intermediate potential so as to prevent the noise signal from having a prescribed level or lower, during the noise reading period.

According to this composition, even if the transfer transistor is completely off or is driven at an intermediate potential during the noise reading period, the photoelectric conversion element continues exposure, and therefore a signal charge flows into the floating diffusion from the photoelectric conversion element if a subject of very high brightness is being exposed. In this case, the level of the noise signal read out in the noise reading period is much lower than the expected level.

On the other hand, if a subject of very high brightness is exposed, the level of the noise-plus-image signal read out during the signal reading period becomes low. Therefore, if the difference between the noise signal and the noise-plus-image signal is found by a correlated double sampling circuit, then the level of the noise signal read out during the noise reading period is significantly lower than the original level, and hence a so-called white/black reversal effect occurs in which the level of the image signal becomes significantly lower than the originally obtained image signal.

In the composition described above, since the noise signal read out during the noise reading period is prevented from becoming equal to or lower than a prescribed level, then even if a subject of very high brightness is exposed, the noise signal is maintained at a prescribed level, and when the difference between the noise signal and the noise-plus-image signal is found by correlated double sampling, it is possible to obtain an image signal of a level close to the level obtained originally, and a white/black reversal effect can be suppressed.

## Claims

1. A solid-state imaging device of CMOS type, comprising:
a plurality of pixel circuits having photoelectric conversion characteristics including linear characteristics and logarithmic characteristics on either side of an inflection point,
wherein the pixel circuits each include:
a photoelectric conversion element which accumulates a signal charge by exposing a subject; and
a floating diffusion which converts the signal charge accumulated by the photoelectric conversion element into a voltage signal, and
the floating diffusion is set to have an operating charge smaller than a saturation charge of the photoelectric conversion element.

2. The solid-state imaging device according to claim 1,
wherein the pixel circuits each include a transfer transistor which transfers the signal charge accumulated by the photoelectric conversion element, to the floating diffusion,
the solid-state imaging device further comprising a control unit which drives the transfer transistor at an intermediate potential during an exposure period.

3. The solid-state imaging device according to claim 2,
further comprising a temperature detection unit which detects a temperature of each of the pixel circuits,
wherein the control unit changes the intermediate potential on the basis of a temperature detected by the temperature detection unit in such a manner that variation in the inflection point in each of the pixel circuits is suppressed.

4. The solid-state imaging device according to claim 2 or 3,
wherein a plurality of types of the pixel circuits are provided,
the control unit generates a predetermined intermediate potential in accordance with the type of pixel circuit, and
the transfer transistor is driven by the control unit at an intermediate potential corresponding to the type of pixel circuit to which the transfer transistor belongs.

5. The solid-state imaging device according to any one of claims 2 to 4,
wherein the pixel circuits each include:
a reset transistor which resets the floating diffusion; and
a row selection transistor which outputs a voltage signal of the floating diffusion as a pixel signal, and
the control unit resets the floating diffusion by switching the reset transistor on during an exposure period, and switches the reset transistor off, switches the transfer transistor off, and switches the row selection transistor on, during a noise reading period which follows the exposure period.

6. The solid-state imaging device according to any one of claims 2 to 4,
wherein the pixel circuits each include:
a reset transistor which resets the floating diffusion; and
a row selection transistor which outputs a voltage signal of the floating diffusion as a pixel signal, and
the control unit resets the floating diffusion by switching the reset transistor on during an exposure period, and switches the reset transistor off, drives the transfer transistor at the intermediate potential, and switches the row selection transistor on, during a noise reading period which follows the exposure period.

7. The solid-state imaging device according to claim 6,
wherein the control unit switches the transfer transistor on so as to transfer the charge accumulated in the photoelectric conversion element, to the floating diffusion, during a transfer period which follows the noise reading period, and drives the transfer transistor at the intermediate potential and switches the row selection transistor on, during a signal reading period which follows the transfer period.

8. The solid-state imaging device according to any one of claims 1 to 7,
wherein the pixel circuits constitute a pixel array unit arranged in a matrix of a prescribed number of rows and a prescribed number of columns,
the solid-state imaging device further comprises a vertical scanning unit which sequentially selects rows of the pixel array unit; and
a plurality of reading units which are provided so as to correspond to columns of the pixel unit, read out a pixel signal from the pixel circuit of the row selected by the vertical scanning unit and convert the pixel signal from analog to digital, and
the reading units each include:
a correlated double sampling circuit which eliminates a noise component from a noise-plus-image signal which is a pixel signal output from each of the pixel circuits during the signal reading period, by subtracting the noise-plus-image signal from a noise signal which is a pixel signal output from each of the pixel circuits during the noise reading period; and
a dark current removing unit which inputs an offset signal for removing a dark current component included in the noise-plus-image signal, into the correlated double sampling circuit, during the signal reading period.

9. The solid-state imaging device according to claim 8,
wherein the reading circuits each include:
a noise level limiting transistor connected to an input terminal of the correlated double sampling circuit, and
the control unit drives the noise level limiting transistor at a prescribed intermediate potential so as to prevent the noise signal from having a prescribed level or lower, during the noise reading period.
